# FASCICULE DE BREVET EUROPEEN

(11) **EP 3 413 127 B1**
(45) Date de publication et mention de la délivrance du brevet: **04.12.2019**
(21) Numéro de dépôt: 18174229.7
(22) Date de dépôt: 25.05.2018
(51) Int. Cl.: G02F 2/00, H01Q 1/38

(54) **ELEMENT DE CONVERSION SPECTRALE POUR RAYONNEMENT ELECTROMAGNETIQUE**
ELEMENT ZUR SPEKTRALUMWANDLUNG FÜR ELEKTROMAGNETISCHE STRAHLUNG
SPECTRAL CONVERSION ELEMENT FOR ELECTROMAGNETIC RADIATION

(30) Priorité: 06.06.2017 FR 1755016
(43) Date de publication de la demande: 12.12.2018
(73) Titulaire: Office National d'Etudes et de Recherches Aérospatiales, 91120 Palaiseau (FR)
(72) Inventeur: BOUCHON, Patrick, 91370 VERRIERES LE BUISSON (FR); HAIDAR, Riad, 75012 PARIS (FR); MAKHSIYAN, Mathilde, 01120 LA BOISSE (FR)
(74) Mandataire: Plasseraud IP

(56) Documents cités:
- RU-C2- 2 482 527
- RU-C2- 2 606 516
- ZAGUBISALO P S ET AL: "Simulation of the thermophysical processes in the subterahertz imager based on a thin-film metamaterial converter", RADIOPHYSICS AND QUANTUM ELECTRONICS, SPRINGER NEW YORK LLC, US; RU, vol. 56, no. 1, 1 août 2013 (2013-08-01), pages 20-35, XP035360357, ISSN: 0033-8443, DOI: 10.1007/S11141-013-9413-5 [extrait le 2013-08-01]
- PRADERE C ET AL: "New 2D TeraHertz sensor based on arrayed thermal converter coupled to infrared temperature flux measurement", INFRARED MILLIMETER AND TERAHERTZ WAVES (IRMMW-THZ), 2010 35TH INTERNATIONAL CONFERENCE ON, IEEE, PISCATAWAY, NJ, USA, 5 septembre 2010 (2010-09-05), page 1, XP031783089, ISBN: 978-1-4244-6655-9

## Description

La présente invention concerne un élément de conversion spectrale pour rayonnement électromagnétique, et un procédé de collecte d'un rayonnement Térahertz.

Dans le cadre de la présente description, on appelle rayonnement Térahertz un rayonnement électromagnétique dont la longueur d'onde est comprise entre 30 µm (micromètre) et 3 mm (millimètre), correspondant à une fréquence qui est comprise entre 0,1 THz (Térahertz), soit 100 MHz (Mégahertz), et 10 THz.

On appelle rayonnement infrarouge un rayonnement électromagnétique dont la longueur d'onde est comprise entre 1 µm et 30 µm, correspondant à une fréquence qui est comprise entre 10 THz et 300 THz.

Le document RU2482527 C2 décrit un élément de conversion spectrale qui comprend des antennes absorbant un rayonnement Térahertz et des antennes produisant un rayonnement infrarouge.

L'imagerie infrarouge, basée sur la détection d'images qui sont formées à partir de rayonnement infrarouge, dites images infrarouges, est très utilisée pour de nombreuses applications. De ce fait, des caméras infrarouges sont disponibles aujourd'hui à coût réduit, notamment des caméras qui fonctionnent dans les domaines spectraux de longueur d'onde compris entre 3 µm et 5 µm, ou compris entre 8 µm et 12 µm.

De nombreuses applications ont par ailleurs été identifiées pour des systèmes d'imagerie efficaces pour saisir des images qui sont formées par du rayonnement Térahertz, c'est-à-dire dont l'information d'image correspond à des sources, des réflecteurs ou des diffuseurs de rayonnement Térahertz présents dans un champ d'observation. Toutefois, le développement de capteurs d'images qui soient sensibles à du rayonnement Térahertz nécessite des investissements importants, si bien que de tels capteurs ne sont pas disponibles à ce jour à des prix qui seraient compatibles avec les applications envisagées.

A partir de cette situation, un but de la présente invention consiste à fournir des images qui révèlent des sources, réflecteurs ou diffuseurs de rayonnement Térahertz présents dans un champ d'observation, à un coût qui est faible, c'est-à-dire de l'ordre de ou peu supérieur à celui d'un système d'acquisition d'images infrarouges.

Un but annexe de l'invention est de fournir de telles images qui appartiennent au domaine spectral du rayonnement Térahertz, avec des systèmes d'imagerie qui soient simples et faciles d'utilisation.

Un autre but de l'invention est de fournir des images qui appartiennent au domaine spectral du rayonnement Térahertz, avec des résolutions spatiales qui soient fines.

Encore un autre but de l'invention est de fournir des images qui appartiennent au domaine spectral du rayonnement Térahertz, mais qui sont restreintes à l'intérieur de fenêtres spectrales prédéterminées et facilement variables. Un but complémentaire peut alors être de fournir facilement des images multispectrales dont certaines au moins des composantes appartiennent au domaine spectral du rayonnement Térahertz.

Pour atteindre l'un au moins de ces buts ou d'autres, un premier aspect de l'invention propose un élément de conversion spectrale pour rayonnement électromagnétique, qui comprend :
- un support bidimensionnel, avec des zones juxtaposées qui sont dédiées respectivement à des pixels ;
- un ensemble de premières antennes, dites antennes Térahertz, qui sont portées fixement par le support bidimensionnel et dimensionnées pour présenter un premier pic d'absorption du rayonnement électromagnétique lorsqu'une longueur d'onde du rayonnement est comprise entre 30 µm et 3 mm, au moins une des antennes Térahertz étant située à l'intérieur de chaque zone de pixel ; et
- un ensemble de secondes antennes, dites antennes infrarouges, qui sont aussi portées fixement par le support bidimensionnel mais dimensionnées pour présenter un second pic d'absorption du rayonnement électromagnétique lorsque la longueur d'onde du rayonnement est comprise entre 1 µm et 30 µm, au moins une des antennes infrarouges étant située à l'intérieur de chaque zone de pixel.

Autrement dit, chaque antenne Térahertz est absorbante pour du rayonnement Térahertz, possiblement à l'intérieur d'une partie restreinte de l'ensemble du domaine spectral Térahertz, et aussi possiblement avec une sélectivité par rapport à la polarisation de ce rayonnement.

Simultanément, chaque antenne infrarouge est absorbante pour du rayonnement infrarouge. D'après la loi de Kirchhoff supposée bien connue, chaque antenne infrarouge est aussi efficace pour émettre du rayonnement infrarouge dans une fenêtre spectrale qui est superposée au second pic d'absorption du rayonnement électromagnétique.

Selon une caractéristique de l'invention, l'élément de conversion est agencé de sorte qu'une des antennes Térahertz et une des antennes infrarouges qui sont situées toutes deux dans une même zone de pixel, quelle que soit cette zone de pixel, soient couplées thermiquement l'une à l'autre avec une résistance thermique qui est inférieure à chaque autre résistance thermique qui existe entre l'une quelconque des antennes Térahertz et l'une quelconque des antennes infrarouges lorsque ces antennes Térahertz et infrarouge sont situées dans des zones de pixels respectives qui sont différentes. Autrement dit, chaque zone de pixel réalise un couplage thermique entre les antennes Térahertz et infrarouge de cette zone, mais avec une interférence entre zones de pixels différentes, couramment désignée par «crosstalk» en anglais, qui est réduite.

L'élément de conversion de l'invention réalise donc une conversion d'énergie à l'intérieur de chaque zone de pixel, entre le rayonnement Térahertz qui est incident sur chaque première antenne de cette zone de pixel et du rayonnement infrarouge qui est émis par chaque seconde antenne de cette même zone de pixel. En outre, les premières antennes déterminent la fenêtre spectrale de sensibilité de l'élément de conversion pour le rayonnement Térahertz incident, et les secondes antennes déterminent la fenêtre spectrale d'émission du rayonnement infrarouge. L'énergie du rayonnement Térahertz dans la fenêtre spectrale des premières antennes est ainsi convertie en énergie de rayonnement infrarouge dans la fenêtre spectrale des secondes antennes. La conversion est réalisée à l'intérieur de zones de pixels qui sont découplées les unes des autres, pour constituer une matrice qui permet de conserver une indication de la zone spatiale dans laquelle le rayonnement Térahertz est ou a été incident.

Lorsqu'il est disposé dans un plan objet d'un instrument de saisie d'image infrarouge, l'élément de conversion de l'invention permet à l'instrument de saisir des images qui révèlent des sources, des réflecteurs ou des diffuseurs de rayonnement Térahertz présents dans un champ d'observation. Ainsi, de telles images Térahertz peuvent être saisies pour un coût qui est sensiblement similaire à la somme du coût de l'instrument de saisie d'image infrarouge et de l'élément de conversion proposé par l'invention. Or l'élément de conversion de l'invention, parce qu'il peut être fabriqué par des techniques de gravure et de dépôt de matériaux qui sont maîtrisées à ce jour, peut avoir un prix de revient qui est compatible avec les applications envisagées.

Préférablement, l'élément de conversion peut être agencé de sorte que chaque résistance thermique entre une antenne Térahertz et une antenne infrarouge qui sont situées toutes deux dans une même zone de pixel, quelle que soit cette zone de pixel, soit inférieure à un dixième, de préférence inférieure à un centième, de chaque autre résistance thermique qui existe entre l'une quelconque des antennes Térahertz et l'une quelconque des antennes infrarouges lorsque ces antennes Térahertz et infrarouge sont situées dans des zones de pixels respectives qui sont différentes. Ainsi, les interférences - ou «crosstalk» - entre zones de pixels différentes de l'élément de conversion sont suffisamment réduites pour qu'une image infrarouge qui soit nette résulte de la conversion d'énergie du rayonnement Térahertz reçu, en rayonnement infrarouge, séparément pixel par pixel.

Dans divers modes de réalisation de l'invention, chaque antenne Térahertz ou infrarouge peut être du type métal-diélectrique-métal, ou être du type résonateur de Helmholtz, ou encore être formée par une portion d'un matériau qui est absorbant pour le rayonnement Térahertz ou infrarouge, respectivement.

De façon générale pour l'invention, les dimensions transversales suivantes, mesurées parallèlement au support bidimensionnel, sont avantageuses :
- entre 30 µm et 5000 µm, c'est-à-dire 5 mm, pour chaque zone de pixel,
- entre 1 µm et 300 µm pour chaque antenne Térahertz, et
- entre 0,1 µm et 5 µm pour chaque antenne infrarouge.

Pour produire un découplage encore plus efficace entre deux zones de pixels quelconques qui sont voisines, le support bidimensionnel peut présenter une portion de liaison pour relier deux zones de pixels voisines, et présenter des évidements qui limitent transversalement chaque portion de liaison. Ainsi, toutes les zones de pixels peuvent être solidaires dans le support bidimensionnel, alors que des passages de diffusion thermique entre deux zones de pixels qui sont voisines ont des sections qui sont restreintes par certains des évidements. L'élément de conversion de l'invention peut ainsi former une pièce unique qui est facile à manipuler et à incorporer dans un instrument d'imagerie.

Possiblement, chaque antenne Térahertz peut posséder une géométrie qui est sélectionnée parmi plusieurs géométries distinctes correspondant à des polarisations différentes ou des longueurs d'onde différentes pour le rayonnement électromagnétique qui est absorbé avec une efficacité maximale. Dans ce cas, chaque zone de pixel peut comporter au moins une de ces géométries d'antennes Térahertz, de préférence une seule géométrie d'antenne par zone de pixel. Les géométries d'antennes Térahertz sont alors alternées entre des zones de pixels qui sont différentes, préférablement selon un motif d'alternance qui est identique dans tout l'élément de conversion. L'élément de conversion peut ainsi produire des images multispectrales et/ou des images qui correspondent à des polarisations différentes du rayonnement Térahertz qui est absorbé. De cette façon, une information plus complète peut être recueillie sur les sources, réflecteurs et diffuseurs de rayonnement Térahertz qui sont présents dans un champ d'observation. Lorsque chaque zone de pixel ne comporte qu'une seule géométrie d'antenne, les différentes composantes spectrales de chaque image multispectrale, ou les différentes composantes de polarisation de chaque image multi-polarisation, présentent une diaphonie, ou «crosstalk» en anglais, qui est très réduite ou nulle. Toutefois, une résolution qui est plus fine peut être obtenue pour l'image multispectrale ou multi-polarisation lorsque des antennes de géométries différentes sont contenues dans chaque zone de pixel.

Selon des premières configurations, dites en transmission, qui sont possibles pour des éléments de conversion conformes à l'invention, les antennes Térahertz d'une part, et les antennes infrarouges d'autre part, peuvent être portées par deux faces opposées du support bidimensionnel. Les résistances thermiques sont alors produites le long de chemins de diffusion thermique qui traversent le support bidimensionnel entre les deux faces opposées.

Selon des secondes configurations, dites en réflexion, qui sont aussi possibles pour des éléments de conversion conformes à l'invention, les antennes Térahertz et les antennes infrarouges peuvent être portées ensemble par une même face du support bidimensionnel. Par exemple, les antennes Térahertz peuvent être réparties dans une première partie d'une structure en couches qui est portée par la face du support bidimensionnel, et les antennes infrarouges peuvent être réparties dans une seconde partie de la même structure en couches qui est située au-dessus ou au-dessous de la première partie, par rapport à un ordre d'empilement des couches sur la face du support bidimensionnel.

Un second aspect de l'invention propose un procédé de collecte d'un rayonnement Térahertz, qui comprend les actions suivantes :
- disposer un élément de conversion qui est conforme au premier aspect de l'invention, dans du rayonnement Térahertz de sorte que l'élément de conversion produise un rayonnement infrarouge à partir d'une énergie du rayonnement Térahertz ; et
- disposer un capteur du rayonnement infrarouge sur un trajet du rayonnement infrarouge qui est produit par l'élément de conversion.

Pour des applications diverses qui n'appartiennent pas au domaine de l'imagerie, le capteur du rayonnement infrarouge peut comprendre au moins une cellule photovoltaïque, une cellule photoconductrice, ou une cellule bolométrique, qui est efficace pour absorber une partie au moins du rayonnement infrarouge produit par l'élément de conversion.

Pour des applications d'imagerie, le capteur du rayonnement infrarouge peut comprendre au moins un détecteur d'image qui est sensible au rayonnement infrarouge. Le procédé comprend alors en outre les actions de :
- disposer un objectif qui est efficace pour le rayonnement Térahertz sur un trajet de ce rayonnement Térahertz en amont de l'élément de conversion ; et
- disposer aussi un système imageur qui est efficace pour le rayonnement infrarouge sur un trajet du rayonnement infrarouge entre l'élément de conversion et le détecteur d'image.

L'objectif forme ainsi une image d'une scène sur l'élément de conversion avec le rayonnement Térahertz qui provient de la scène, et le système imageur forme une image de l'élément de conversion sur le détecteur d'image avec le rayonnement infrarouge qui est produit par l'élément de conversion.

D'autres particularités et avantages de la présente invention apparaîtront dans la description ci-après d'exemples de réalisation non limitatifs, en référence aux dessins annexés, dans lesquels :
- la figure 1 est une vue en coupe transversale d'un élément de conversion conforme à l'invention ;
- les figures 2a et 2b représentent l'élément de conversion de la figure 1, vu en plan par dessus et par dessous ;
- la figure 3 est un diagramme spectral d'absorption de rayonnement électromagnétique, relatif à des antennes d'un élément de conversion conforme à l'invention ;
- les figures 4a à 4c illustrent trois modes de réalisation possibles pour des antennes d'éléments de conversion conformes à l'invention ; et
- la figure 5 correspond à la figure 1 pour une configuration différente d'un élément de conversion aussi conforme à l'invention.

Pour raison de clarté, les dimensions des éléments qui sont représentés dans ces figures ne correspondent ni à des dimensions réelles ni à des rapports de dimensions réels. En outre, des références identiques qui sont indiquées dans des figures différentes désignent des éléments identiques ou qui ont des fonctions identiques.

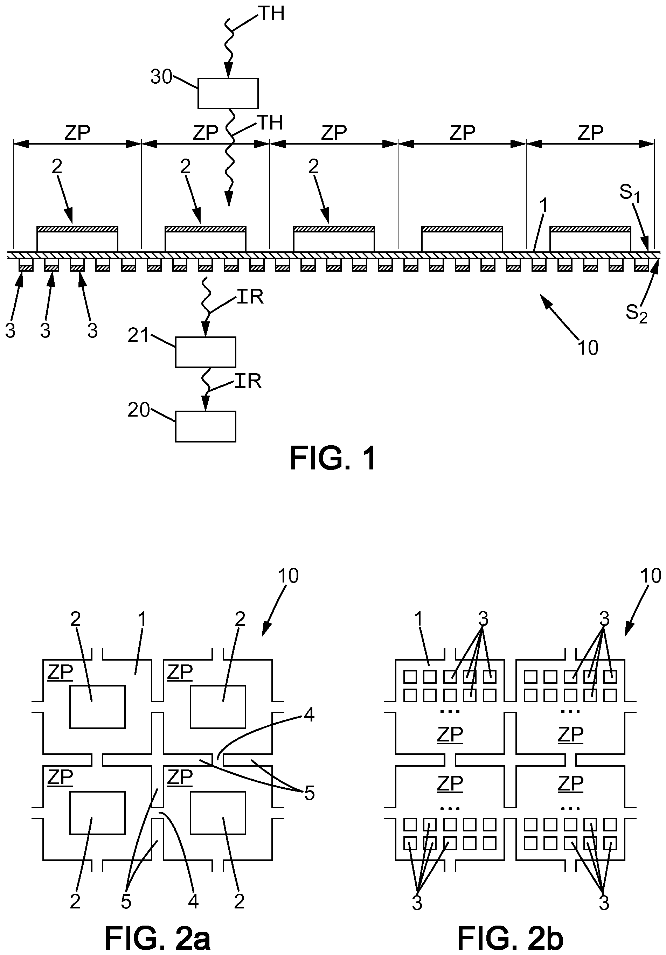

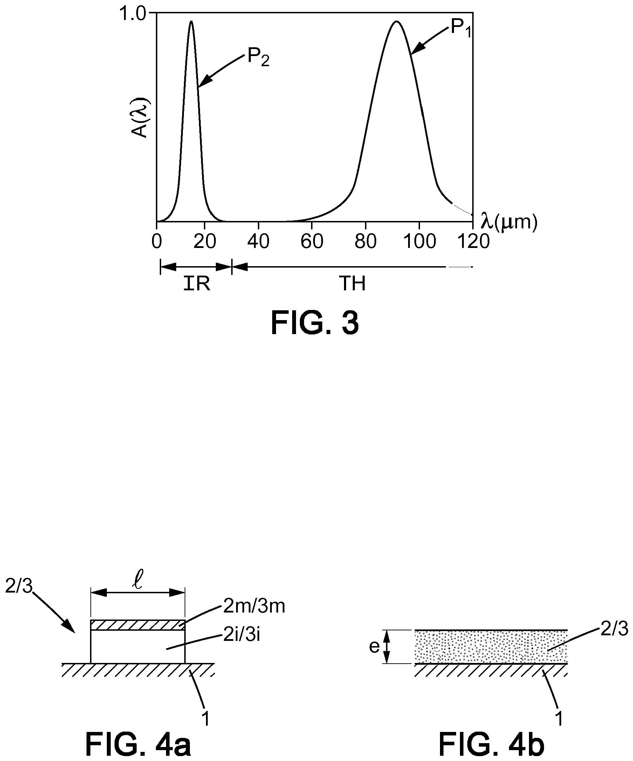

Conformément aux figures 1, 2a et 2b, un support bidimensionnel 1 qui peut être de la forme d'un film à simple couche ou multicouche, possède deux faces opposées notées S₁ et S₂ respectivement. La face S₁ porte des antennes 2, et la face S₂ porte des antennes 3. Les antennes 2 et 3 possèdent des intervalles spectraux d'absorption de rayonnement électromagnétique qui sont séparés, comme représenté dans le diagramme de la figure 3 : les antennes 2 sont absorbantes pour des valeurs de longueur d'onde du rayonnement électromagnétique qui appartiennent au domaine 30 µm - 3 mm, correspondant à du rayonnement Térahertz, et les antennes 3 sont absorbantes pour des valeurs de longueur d'onde du rayonnement électromagnétique qui appartiennent au domaine 1 µm - 30 µm, correspondant à du rayonnement infrarouge. Dans la figure 3, λ désigne la longueur d'onde du rayonnement électromagnétique, exprimée en micromètres, et A(λ) désigne l'absorption spectrale de ce rayonnement. IR désigne le domaine spectral du rayonnement infrarouge, et TH désigne le domaine spectral du rayonnement Térahertz. Possiblement, chaque antenne 2, dite antenne Térahertz, peut être absorbante sélectivement à l'intérieur d'un pic noté P₁, qui correspond à une bande réduite, ou très réduite à l'intérieur de l'intervalle spectral du rayonnement Térahertz. De même, chaque antenne 3, dite antenne infrarouge, peut être absorbante sélectivement à l'intérieur d'un pic noté P₂, qui correspond à une bande réduite à l'intérieur de l'intervalle spectral du rayonnement infrarouge.

De façon générale, l'absorption de rayonnement électromagnétique par une structure matérielle dépend des matériaux de cette structure, et éventuellement en outre de ses dimensions géométriques. Ainsi, chaque antenne Térahertz 2 possède une structure qui est conçue pour présenter une absorption importante dans le domaine spectral du rayonnement Térahertz (pic P₁ du diagramme de la figure 3).

Selon un premier mode de réalisation possible qui est illustré par la figure 4a, chaque antenne 2 peut être constituée d'une portion 2i de matériau isolant électriquement, qui est intercalée entre deux portions de couches conductrices électriquement, de préférence entre deux portions de couches métalliques. L'une de ces portions est désignée par la référence 2m, et l'autre peut être formée par une partie de la face du support 1. Une telle structure d'antenne est connue sous la désignation métal-isolant-métal, et est grandement documentée dans la littérature disponible. Elle forme un résonateur de Fabry-Pérot, pour lequel la position en longueur d'onde du pic d'absorption P₁ dépend des dimensions de la portion 2m mesurées parallèlement à la face du support 1. Par exemple, une longueur l de la portion métallique 2m, appelée longueur de cavité et mesurée parallèlement au support 1, correspond à une longueur d'onde d'absorption maximale d'environ quatre fois cette longueur de cavité l, lorsque la portion de matériau isolant 2i est en polyimide, polyméthylméthacrylate (PMMA), polyéthylène (PET), ou en résine photosensible négative à base d'époxy, telle que connue sous l'acronyme SU-8. La portion de couche métallique 2m peut être en or, cuivre ou aluminium, par exemple.

Lorsque les longueurs de diffusion thermique qui existent parallèlement au support 1, entre des antennes 2 qui sont voisines, sont très supérieures aux longueurs de diffusion thermique qui existent perpendiculairement au support 1, entre des antennes 2 et 3 qui sont couplées à l'intérieur d'une même zone de pixel, le matériau isolant 2i peut être continu entre des antennes 2 qui sont voisines. Il peut ainsi former une couche qui est continue, et qui peut servir de support mécanique pour l'élément de conversion spectrale.

Selon un deuxième mode de réalisation possible qui est illustré par la figure 4b, chaque antenne 2 peut être constituée d'une portion d'un matériau qui présente une absorption importante du rayonnement électromagnétique, lorsque ce rayonnement possède une longueur d'onde qui est comprise entre 30 µm et 3 mm. Par exemple, une couche d'un polymère dopé, tel que du PMMA dopé ou du PET dopé, d'épaisseur e = 5 µm environ lorsqu'elle est mesurée perpendiculairement au support 1, et qui est déposée sur un film métallique qui constitue ce support 1, peut constituer une antenne 2 pour laquelle l'absorption se produit de façon à peu près homogène sur toute la bande de rayonnement Térahertz. Comme précédemment, lorsque les longueurs de diffusion thermique qui existent entre des antennes 2 qui sont voisines sont très supérieures aux longueurs de diffusion thermique qui existent entre des antennes 2 et 3 qui sont couplées à l'intérieur d'une même zone de pixel, la couche de polymère dopé qui constitue les portions absorbantes du rayonnement Térahertz peut être continue entre des antennes 2 voisines. Elle peut alors aussi remplir la fonction de support mécanique pour l'élément de conversion spectrale.

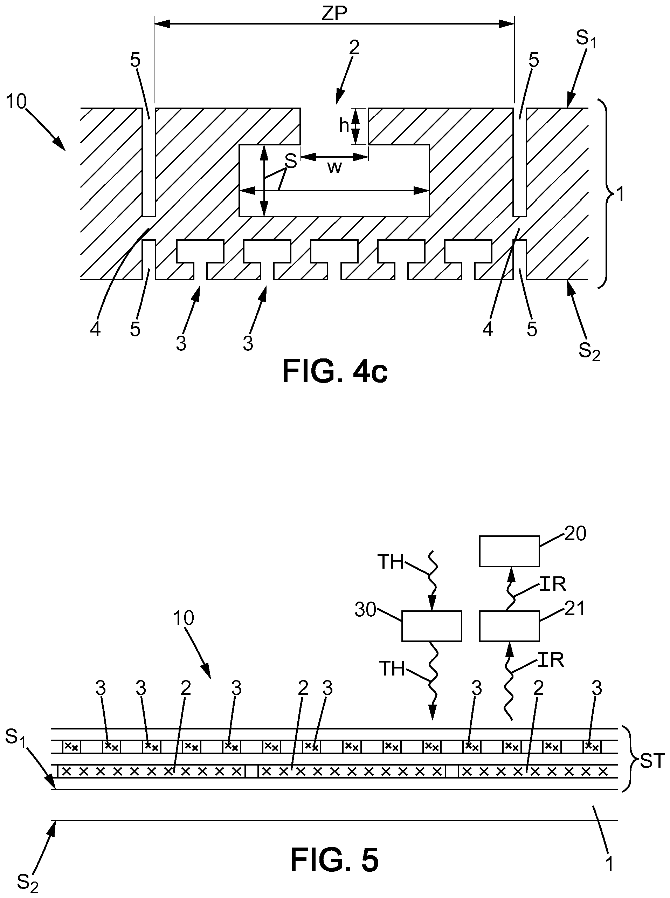

Selon un troisième mode de réalisation possible qui est illustré par la figure 4c, chaque antenne 2 peut être constituée par un résonateur de Helmholtz. Un tel résonateur est constitué par une cavité à parois métalliques, qui est reliée à l'extérieur par un col. De façon avantageuse mais non-limitative pour ce mode de réalisation, le support 1 peut être en matériau métallique, et la cavité et le col sont formés dans le support 1 à partir de la face S₁. La cavité et le col peuvent être très allongés perpendiculairement au plan de la figure 4c, et dans ce plan, la cavité possède une surface de section S, et le col possède une largeur w et une hauteur h. Par exemple, les valeurs suivantes : S = 6 µm², w = 0,2 µm et h = 1 µm, produisent un pic d'absorption P₁ qui est centré approximativement sur la valeur de longueur d'onde 50 µm. Une bibliographie abondante est aussi disponible au sujet de tels résonateurs de Helmholtz.

Dans ces exemples numériques, l'autre dimension de l'antenne 2, qui est mesurée aussi parallèlement au support 1, est supposée très supérieure à la première dimension donnée précédemment. Toutefois, une telle géométrie quasi-unidimensionnelle pour chaque antenne n'est pas indispensable. Par exemple, pour le premier mode de réalisation de la figure 4a, à base d'une portion de matériau isolant électriquement qui est intercalée entre deux portions de couches conductrices électriquement, des géométries bidimensionnelles peuvent être utilisées comme représenté sur les figures 2a et 2b. En particulier, chaque antenne peut avoir une forme rectangulaire dans un plan de projection qui est parallèle au support 1.

Pour un élément de conversion tel que représenté aux figures 1, 2a et 2b, chaque antenne Térahertz est portée par le support 1 de façon à être couplée thermiquement avec lui, de sorte que l'absorption de rayonnement Térahertz par cette antenne 2 produise de la chaleur qui est transférée au support 1. Par exemple, pour le premier mode de réalisation des antennes 2 (figure 4a), le support 1 peut former directement l'une des deux portions de couches conductrices électriquement. Pour le deuxième mode de réalisation (figure 4b), la portion du matériau qui est absorbant pour le rayonnement Térahertz peut être formée directement sur le support 1. Enfin, pour le troisième mode de réalisation (figure 4c), le support 1 peut être en matériau métallique, et être suffisamment épais pour que la cavité et le col puissent être formés dans le support 1 à partir de sa face S₁.

Pour les trois modes de réalisation, le support 1 peut être un film d'or (Au), de cuivre (Cu) ou d'aluminium (Al), à titre d'exemples non-limitatifs.

Chaque antenne infrarouge 3 a pour fonction d'émettre du rayonnement infrarouge dans la bande spectrale de longueur d'onde qui est comprise entre 1 µm et 30 µm, lorsqu'elle reçoit de la chaleur qui a été produite par l'absorption de rayonnement Térahertz par l'une des antennes 2. Chaque antenne 3 est constituée d'au moins une autre portion d'un matériau approprié, qui émet du rayonnement infrarouge en fonction de la température de cette portion. Lorsque cette température augmente, du fait de la chaleur reçue par diffusion thermique en provenance de l'une des antennes Térahertz 2, la quantité du rayonnement infrarouge émis augmente aussi, mais tout en restant limitée par la valeur d'émissivité du matériau de cette antenne 3. Toutefois, la structure d'antenne qui présente le pic d'absorption P₂ assure que cette émissivité est importante. Dit autrement, une structure d'antenne qui présente un pic d'absorption du rayonnement électromagnétique est aussi efficace pour émettre du rayonnement électromagnétique à la longueur d'onde de ce pic d'absorption, lorsqu'elle est chauffée.

Les trois modes de réalisation qui ont été décrits plus haut pour les antennes Térahertz 2 peuvent être repris dans leurs principes pour les antennes infrarouges 3, en adaptant toutefois les matériaux utilisés et les dimensions géométriques pour un pic d'absorption P₂ qui est situé dans l'intervalle de longueur d'onde compris entre 1 µm et 30 µm.

En particulier, pour le premier mode de réalisation, de type métal-isolant-métal, la portion matériau isolant, maintenant référencée 3i dans la figure 4a, peut être en sulfure de zinc (ZnS), mais aussi en silice (SiO₂), en carbure de silicium (SiC), en silicium ou en germanium, alors que la portion de matériau conducteur électriquement 3m ainsi que la partie concernée du support 1 peuvent encore être or, cuivre ou aluminium. La formule numérique des résonateurs de Fabry-Pérot est encore applicable pour ce mode de réalisation des antennes 3, pour déterminer la longueur de cavité l en fonction de la longueur d'onde d'absorption maximale qui est désirée pour le pic P₂. Par exemple, lorsque la portion de matériau 3i est en sulfure de zinc, la valeur de 2 µm pour la longueur de cavité l produit la valeur de 10 µm pour la longueur d'onde centrale du pic d'absorption P₂.

Pour le deuxième mode de réalisation (figure 4b), le matériau absorbant à utiliser pour chaque antenne infrarouge 3 peut être de la silice (SiO₂). Lorsque l'épaisseur e de cette couche de silice est de 0,7 µm environ, et que cette couche est encore déposée sur un film métallique qui constitue le support 1, une émissivité moyenne qui est supérieure à 50% est obtenue dans l'intervalle de longueur d'onde compris entre 8 µm et 12 µm.

Enfin, pour le troisième mode de réalisation, à résonateur de Helmholtz, les valeurs 0,65 µm² pour la section de cavité S, 0,2 µm pour la largeur de col w, et 0,5 µm pour la hauteur de col h, correspondent à une longueur d'onde centrale de 10 µm pour le pic d'absorption P₂.

Le support 1 et les antennes 2 et 3 qui sont portées par celui-ci forment un élément de conversion spectral conforme à l'invention, désigné globalement par la référence 10. Pour le fonctionnement de cet élément de conversion 10, chaque antenne Térahertz 2 doit être couplée thermiquement de façon efficace à au moins une antenne infrarouge 3 qui lui est associée. Toutefois, plusieurs antennes infrarouges 3 peuvent être associées à une même antenne Térahertz 2. Par antenne 2 qui est couplée thermiquement avec une antenne 3 de façon efficace, on entend que la résistance de diffusion thermique entre ces deux antennes est inférieure d'un facteur au moins 10 ou 100, à une résistance de diffusion thermique qui existe entre l'antenne 2 et une antenne 3 qui ne lui est pas associée. Un tel couplage thermique sélectif peut être obtenu par une répartition appropriée des antennes 2 et 3 parallèlement au support bidimensionnel 1 : des antennes 2 et 3 qui sont associées l'une avec l'autre peuvent être situées au droit l'une de l'autre selon la direction perpendiculaire à la face S₁ du support 1, ou peu éloignées l'une de l'autre parallèlement à la face S₁, alors que des antennes 2 et 3 qui ne sont pas associées sont plus éloignées l'une de l'autre parallèlement à la face S₁.

Selon une conception pratique de l'élément de conversion 10, des zones distinctes, dites zones de pixels, sont définies sur le support bidimensionnel 1, sur sa face S₁, par exemple selon une répartition matricielle, en lignes et en colonnes perpendiculaires. Deux antennes 2 et 3 qui sont alors situées dans une même zone de pixel ZP sont couplées thermiquement entre elles au sens qui a été défini plus haut, alors que des antennes 2 et 3 qui sont situées dans des zones de pixels ZP différentes présentent entre elles un couplage thermique moins intense, c'est-à-dire une résistance de diffusion thermique inter-pixel qui est au moins 10 fois, sinon au moins 100 fois, supérieure à la résistance de diffusion thermique intra-pixel.

Pour augmenter encore le rapport entre les valeurs de résistance de diffusion thermique inter-pixel et intra-pixel, il est possible pour le support 1 de présenter des découpes entre les zones de pixels ZP. De cette façon, une section de diffusion thermique est réduite entre des zones de pixels ZP qui sont voisines, augmentant ainsi la valeur de résistance de diffusion thermique inter-pixel. Dans les figures 2a et 2b, les références 5 indiquent des découpes, ou évidements, qui sont ménagées entre des zones de pixels ZP qui sont voisines. Les références 4 désignent des portions de liaison résiduelles du support 1, entre les découpes 5, qui assurent la cohésion mécanique de l'ensemble de l'élément de conversion 10.

Pour le mode de réalisation de la figure 4c, dans lequel les antennes 2 et 3 sont toutes du type résonateur de Helmholz, l'élément de conversion 10 peut n'être constitué que du support 1 en matériau métallique, qui est muni des cavités et des cols qui forment les résonateurs. Eventuellement ses faces S₁ et S₂ peuvent être recouvertes d'un matériau isolant, pour protéger les cavités, notamment de la corrosion du matériau métallique. Un tel mode de réalisation nécessite que le support 1 soit plus épais. Alors les évidements 5 peuvent être conçus pour amincir localement le support 1, entre les zones de pixels adjacentes, dans le même but de réduction du couplage thermique inter-pixel.

Par exemple, les zones de pixels ZP peuvent avoir un pas d'environ 1 mm selon les directions de lignes et de colonnes de la matrice de l'élément de conversion 10. A l'intérieur de chaque zone de pixel ZP, chaque antenne Térahertz 2 peut avoir une dimension transversale qui est inférieure à 0,3 mm, parallèlement à la face S₁ du support 1, et chaque antenne infrarouge 2 peut avoir une dimension transversale qui est inférieure à 5 µm, encore parallèlement à la face S₁ du support 1, ces dimensions transversales d'antennes dépendant des longueurs d'onde centrales qui sont voulues pour les pics d'absorption P₁ et P₂, comme expliqué plus haut. Dans ces conditions, chaque zone de pixel ZP peut ne contenir qu'une seule antenne Térahertz 2 et une multitude d'antennes infrarouges 3, ces dernières pouvant être réparties à l'intérieur de la zone de pixel ZP selon un réseau carré, par exemple. Les figures 1, 2a et 2b illustrent une telle géométrie pour l'élément de conversion 10.

Etant donné de telles dimensions pour les zones de pixels ZP et pour les antennes 2 et 3, il est aussi possible de disposer plusieurs antennes Térahertz 2 à l'intérieur de chaque zone de pixel ZP, toutes les zones de pixels ZP ayant des configurations identiques. Ainsi, à l'intérieur de chaque zone de pixel ZP, des antennes Térahertz 2 qui ont des géométries différentes peuvent correspondre à des positions en longueur d'onde du pic d'absorption P₁ qui sont distinctes. La distribution des antennes infrarouges 3 dans chaque zone de pixel ZP permet encore d'émettre du rayonnement infrarouge en réponse à l'absorption de rayonnement Térahertz par l'une quelconque des antennes Térahertz. De cette façon, l'élément de conversion 10 peut présenter un intervalle spectral de sensiblité qui est agrandi, par rapport à l'utilisation d'une seule géométrie d'antennes Térahertz.

Par ailleurs, il est aussi possible d'affecter des géométries différentes d'antennes Térahertz, produisant des positions spectrales différentes pour le pic d'absorption P₁, à des zones de pixels ZP qui sont voisines, notamment en utilisant un motif d'alternance déterminé pour les géométries d'antennes Térahertz entre les zones de pixels ZP, à la façon d'un filtre de Bayer. L'élément de conversion 10 permettra ainsi de relayer des images Térahertz multispectrales, lorsqu'il sera mis en oeuvre pour une fonction d'imagerie comme expliqué plus loin.

Alternativement ou en combinaison, des antennes Térahertz 2 qui ont des géométries différentes peuvent être sensibles à des polarisations distinctes du rayonnement Térahertz. En effet, de façon connue, la forme de chaque antenne 2 parallèlement à la face S₁ du support 1, détermine une polarisation du rayonnement pour laquelle cette antenne présente une efficacité, ou sensibilité, supérieure. Les données d'image qui sont ainsi recueillies comportent une information de polarisation qui peut être utile pour certaines applications, notamment des applications de surveillance d'environnement et de reconnaissance d'éléments intrus.

Un élément de conversion 10 qui est conforme à l'invention peut avoir une configuration en transmission, ou une configuration en réflexion.

Les figures 1, 2a et 2b correspondent à la configuration en transmission. Dans ce cas, les antennes Térahertz 2 et les antennes infrarouges 3 sont situées sur les deux faces opposées du support 1 : les antennes 2 sur la face S₁ et les antennes 3 sur la face S₂, opposée à la face S₁, conformément à la figure 1. Le couplage thermique entre les antennes 2 et 3 est alors produit par des chemins de diffusion thermique qui traversent le support 1 entre les faces S₁ et S₂. Une telle configuration en transmission permet en général des mises en oeuvre de l'élément de conversion 10 qui sont plus simples.

La figure 5 illustre la configuration en réflexion. Dans ce cas, toutes les antennes 2 et 3 sont situées sur la face S₁ du support 1. Selon un mode de réalisation possible pour une telle configuration en réflexion, les antennes 2 et 3 peuvent être réalisées au sein d'une structure multicouche ST qui est formée uniquement sur la face S₁ du support 1. Par exemple, les antennes 2 peuvent être formées au sein d'une partie inférieure de la structure ST, plus proche du support 1, et les antennes 3 peuvent être formées au sein d'une partie supérieure de la structure ST, plus éloignée du support 1. Une telle configuration est favorisée si les antennes infrarouges 3 sont suffisamment transparentes pour le rayonnement Térahertz, qui est destiné aux antennes 2 sous-jacentes au sein de la structure ST. Un avantage d'une telle configuration en réflexion résulte de la proximité accrue entre les antennes 2 et 3 qui sont associées, produisant un couplage thermique entre elles qui est augmenté.

Des premières applications pour un élément de conversion 10 qui est conforme à l'invention, peuvent consister à collecter de l'énergie radiative qui appartient au domaine Térahertz, par exemple en provenance d'une source thermique ou du soleil. Pour cela, la face du support 1 qui porte les antennes Térahertz 2 est exposée au rayonnement Térahertz, et un capteur qui est efficace pour absorber du rayonnement infrarouge, par exemple une cellule photovoltaïque, photoconductrice, ou bolométrique, est placé en vis-à-vis de la face du support 1 qui porte les antennes infrarouges 3. Dans les figures 1 et 5, les références TH et IR désignent respectivement le rayonnement Térahertz dont l'énergie est collectée, et le rayonnement infrarouge qui est transmis au capteur, lui-même désigné par la référence 20. Eventuellement, un concentrateur du rayonnement TH, désigné symboliquement par la référence 30, peut être utilisé pour augmenter la quantité collectée du rayonnement TH. Le concentrateur 30 peut être notamment un miroir, par exemple un miroir parabolique. De même, un concentrateur du rayonnement infrarouge IR, désigné par la référence 21, peut être utilisé entre l'élément de conversion 10 et le capteur infrarouge 20.

Des secondes applications pour un élément de conversion 10 qui est conforme à l'invention, concernent l'acquisition d'images formées avec du rayonnement Térahertz. Pour cela, un objectif qui est efficace pour le rayonnement Térahertz TH est disposé entre une scène à observer et la face du support 1 qui porte les antennes Térahertz 2. La référence 30 désigne maintenant un tel objectif, de façon symbolique pour de telles applications d'imagerie. Un tel objectif peut être à base de miroirs, ou de composants réfringents qui sont efficaces pour le rayonnement Térahertz TH, par exemple en polytétrafluoroéthylène (PTFE connu sous l'appellation commerciale de Teflon™), ou en polyimide, PMMA, PET, etc. La référence 20 désigne alors un détecteur d'image infrarouge, qui est sensible au rayonnement infrarouge IR tel que produit par l'élément de conversion 10. Ce peut être par exemple un détecteur du type matriciel. Dans ces conditions, la référence 21 désigne un système imageur, qui est efficace pour le rayonnement infrarouge IR, et qui conjugue optiquement la face du support 1 qui porte les antennes infrarouges 3 avec la surface photosensible du détecteur d'image 20. La résolution d'image qui est alors obtenue dépend principalement de la taille des zones de pixels ZP de l'élément de conversion 10, ainsi que de la résolution du détecteur d'image 20. En outre, lorsque l'élément de conversion 10 comporte plusieurs antennes Térahertz 2 qui sont différentes dans des zones de pixels ZP séparées, et que celles-ci sont sensibles à des longueurs d'onde différentes du domaine Térahertz, alors l'élément de conversion 10 permet de saisir une image multispectrale à chaque cycle d'acquisition du détecteur d'image 20.

Il est entendu que l'invention peut être reproduite en adaptant ou modifiant certains aspects secondaires de celle-ci par rapport aux modes de réalisation qui ont été décrits en détail ci-dessus. En particulier, l'utilisation des évidements dans le support bidimensionnel entre zones de pixels adjacentes n'est pas indispensable, bien que préférée.

## Revendications

1. Elément de conversion spectrale (10) pour rayonnement électromagnétique, comprenant :
- un support bidimensionnel (1), avec des zones (ZP) juxtaposées qui sont dédiées respectivement à des pixels ;
- un ensemble de premières antennes (2), dites antennes Térahertz, qui sont portées fixement par le support bidimensionnel (1) et dimensionnées pour présenter un premier pic d'absorption (P₁) du rayonnement électromagnétique lorsqu'une longueur d'onde du rayonnement est comprise entre 30 µm et 3 mm, correspondant à du rayonnement dit Térahertz, au moins une des antennes Térahertz étant située à l'intérieur de chaque zone de pixel (ZP) ; et
- un ensemble de secondes antennes (3), dites antennes infrarouges, qui sont aussi portées fixement par le support bidimensionnel (1) mais dimensionnées pour présenter un second pic d'absorption (P₂) du rayonnement électromagnétique lorsque la longueur d'onde du rayonnement est comprise entre 1 µm et 30 µm, correspondant à du rayonnement dit infrarouge, au moins une des antennes infrarouges étant située à l'intérieur de chaque zone de pixel (ZP) ;
l'élément de conversion étant agencé de sorte qu'une des antennes Térahertz (2) et une des antennes infrarouges (3) qui sont situées toutes deux dans une même zone de pixel (ZP), quelle que soit ladite zone de pixel, soient couplées thermiquement l'une à l'autre avec une résistance thermique qui est inférieure à chaque autre résistance thermique qui existe entre l'une quelconque des antennes Térahertz et l'une quelconque des antennes infrarouges lorsque lesdites antennes Térahertz et infrarouge sont situées dans des zones de pixels respectives qui sont différentes,
de sorte que l'élément de conversion soit adapté pour réaliser une conversion d'énergie à l'intérieur de chaque zone de pixel, entre le rayonnement Térahertz qui est incident sur chaque première antenne de ladite zone de pixel et du rayonnement infrarouge qui est émis par chaque seconde antenne de la même zone de pixel.

2. Elément de conversion (10) selon la revendication 1, agencé de sorte que chaque résistance thermique entre une antenne Térahertz (2) et une antenne infrarouge (3) qui sont situées toutes deux dans une même zone de pixel (ZP), quelle que soit ladite zone de pixel, soit inférieure à un dixième, de préférence inférieure à un centième, de chaque autre résistance thermique qui existe entre l'une quelconque des antennes Térahertz et l'une quelconque des antennes infrarouges lorsque lesdites antennes Térahertz et infrarouge sont situées dans des zones de pixels respectives qui sont différentes.

3. Elément de conversion (10) selon la revendication 1 ou 2, dans lequel chaque antenne Térahertz (2) ou infrarouge (3) est de type métal-diélectrique-métal, ou est de type résonateur de Helmholtz, ou est formée par une portion d'un matériau absorbant du rayonnement infrarouge ou Térahertz, respectivement.

4. Elément de conversion (10) selon l'une quelconque des revendications précédentes, dans lequel chaque zone de pixel (ZP) possède des dimensions transversales qui sont comprises entre 30 µm et 5000 µm, chaque antenne Térahertz (2) possède une dimension transversale qui est comprise entre 1 µm et 300 µm, et chaque antenne infrarouge (3) possède une dimension transversale qui est comprise entre 0,1 µm et 5 µm, lesdites dimensions transversales étant mesurées parallèlement au support bidimensionnel (1).

5. Elément de conversion (10) selon l'une quelconque des revendications précédentes, dans lequel le support bidimensionnel (1) présente des portions de liaison (4) pour relier deux zones de pixels (ZP) quelconques qui sont voisines, et présente des évidements (5) qui limitent transversalement chaque portion de liaison, de sorte que toutes les zones de pixels soient solidaires dans ledit support bidimensionnel, et que des passages de diffusion thermique entre deux zones de pixels qui sont voisines aient des sections restreintes par certains des évidements.

6. Elément de conversion (10) selon l'une quelconque des revendications précédentes, dans lequel chaque antenne Térahertz (2) possède une géométrie qui est sélectionnée parmi plusieurs géométries distinctes, lesdites géométries d'antennes Térahertz correspondant à des polarisations différentes ou des longueurs d'onde différentes pour le rayonnement électromagnétique qui est absorbé avec une efficacité maximale, et dans lequel chaque zone de pixel (ZP) comporte au moins une desdites géométries d'antennes Térahertz (2), de préférence une seule géométrie d'antenne, et les géométries d'antennes Térahertz sont alternées entre des zones de pixels qui sont différentes, préférablement selon un motif d'alternance qui est identique dans tout l'élément de conversion (10).

7. Elément de conversion (10) selon l'une quelconque des revendications 1 à 6, dans lequel les antennes Térahertz (2) d'une part, et les antennes infrarouges (3) d'autre part, sont portées par deux faces opposées du support bidimensionnel (1), les résistances thermiques étant produites le long de chemins de diffusion thermique qui traversent le support bidimensionnel entre les deux faces opposées.

8. Elément de conversion (10) selon l'une quelconque des revendications 1 à 6, dans lequel les antennes Térahertz (2) et les antennes infrarouges (3) sont portées ensemble par une même face du support bidimensionnel (1), par exemple les antennes Térahertz sont réparties dans une première partie d'une structure (ST) en couches qui est portée par la face du support bidimensionnel, et les antennes infrarouges sont réparties dans une seconde partie de la structure en couches qui est située au-dessus ou au-dessous de ladite première partie de la structure en couches, par rapport à un ordre d'empilement des couches sur la face du support bidimensionnel.

9. Procédé de collecte d'un rayonnement Térahertz (TH), ledit procédé comprenant :
- disposer un élément de conversion (10) qui est conforme à l'une quelconque des revendications précédentes, dans le rayonnement Térahertz (TH) de sorte que l'élément de conversion produise un rayonnement infrarouge (IR) à partir d'une énergie du rayonnement Térahertz ; et
- disposer un capteur de rayonnement infrarouge (20) sur un trajet du rayonnement infrarouge (IR) qui est produit par l'élément de conversion (10).

10. Procédé selon la revendication 9, suivant lequel le capteur de rayonnement infrarouge (20) comprend au moins une cellule photovoltaïque, une cellule photoconductrice, ou une cellule bolométrique, efficace pour absorber une partie au moins dudit rayonnement infrarouge (IR).

11. Procédé selon la revendication 9, suivant lequel le capteur de rayonnement infrarouge (20) comprend au moins un détecteur d'image qui est sensible au rayonnement infrarouge (IR), et le procédé comprend en outre de disposer un objectif (30) qui est efficace pour le rayonnement Térahertz (TH) sur un trajet dudit rayonnement Térahertz en amont de l'élément de conversion (10), et de disposer aussi un système imageur (21) qui est efficace pour le rayonnement infrarouge sur un trajet dudit rayonnement infrarouge (IR) entre l'élément de conversion (10) et le détecteur d'image (20),
l'objectif (30) formant une image d'une scène sur l'élément de conversion (10) avec le rayonnement Térahertz (TH) qui provient de la scène,
et le système imageur (21) formant une image de l'élément de conversion (10) sur le détecteur d'image (20) avec le rayonnement infrarouge (IR) qui est produit par ledit élément de conversion.

## Patentansprüche

1. Spektralumwandlungselement (10) für elektromagnetische Strahlung, umfassend:
- einen zweidimensionalen Träger (1) mit nebeneinander liegenden Bereichen (ZP), die jeweils Pixeln zugeordnet sind;
- eine Anordnung von als Terahertz-Antennen bezeichneten ersten Antennen (2), die fest von dem zweidimensionalen Träger (1) gehalten und so dimensioniert sind, dass sie eine erste Absorptionsspitze (P₁) der elektromagnetischen Strahlung aufweisen, wenn eine Wellenlänge der Strahlung zwischen 30 µm und 3 mm liegt, entsprechend Strahlung, die als Terahertz-Strahlung bezeichnet wird, wobei sich mindestens eine der Terahertz-Antennen im Inneren von jedem Pixelbereich (ZP) befindet; und
- eine Anordnung von als Infrarot-Antennen bezeichneten zweiten Antennen (3), die ebenfalls fest von dem zweidimensionalen Träger (1) gehalten sind, aber so dimensioniert sind, dass sie eine zweite Absorptionsspitze (P₂) der elektromagnetischen Strahlung aufweisen, wenn die Wellenlänge der Strahlung zwischen 1 µm und 30 µm liegt, entsprechend als Infrarot-Strahlung bezeichneter Strahlung, wobei sich mindestens eine der Infrarot-Antennen im Inneren von jedem Pixelbereich (ZP) befindet; wobei das Umwandlungselement so angeordnet ist, dass eine der Terahertz-Antennen (2) und eine der Infrarot-Antennen (3), die sich alle beide im selben Pixelbereich (ZP) befinden, unabhängig von dem jeweiligen Pixelbereich, thermisch miteinander gekoppelt sind, mit einem thermischen Widerstand, der niedriger ist als jeder andere thermische Widerstand, der zwischen irgendeiner der Terahertz-Antennen und irgendeiner der Infrarot-Antennen besteht, wenn die Terahertz- und Infrarot-Antennen in jeweiligen Pixelbereichen angeordnet sind, die unterschiedlich sind,
so dass das Umwandlungselement angepasst ist, um innerhalb jedes Pixelbereichs eine Energieumwandlung zwischen der Terahertz-Strahlung, die auf jede erste Antenne des Pixelbereichs trifft, und Infrarot-Strahlung durchzuführen, die von jeder zweiten Antenne desselben Pixelbereichs emittiert wird.

2. Umwandlungselement (10) nach Anspruch 1, das so angeordnet ist, dass jeder thermische Widerstand zwischen einer Terahertz-Antenne (2) und einer Infrarot-Antenne (3), die alle beide im selben Pixelbereich (ZP) angeordnet sind, unabhängig von dem jeweiligen Pixelbereich, weniger als ein Zehntel, vorzugsweise weniger als ein Hundertstel, jedes anderen thermischen Widerstands beträgt, der zwischen irgendeiner der Terahertz-Antennen und irgendeiner der Infrarot-Antennen besteht, wenn die Terahertz- und Infrarot-Antennen in jeweils unterschiedlichen Pixelbereichen angeordnet sind.

3. Umwandlungselement (10) nach Anspruch 1 oder 2, wobei jede Terahertz-Antenne (2) oder Infrarot-Antenne (3) vom Typ Metall-Dielektrikum-Metall oder vom Typ Helmholtz-Resonator ist, oder durch einen Abschnitt eines Materials gebildet ist, das absorbierend für Infrarot-Strahlung bzw. Terahertz-Strahlung ist.

4. Umwandlungselement (10) nach einem der vorstehenden Ansprüche, wobei jeder Pixelbereich (ZP) Querabmessungen zwischen 30 µm und 5000 µm aufweist, jede Terahertz-Antenne (2) eine Querabmessung zwischen 1 µm und 300 µm aufweist, und jede Infrarot-Antenne (3) eine Querabmessung zwischen 0,1 µm und 5 µm aufweist, wobei die Querabmessungen parallel zu dem zweidimensionalen Träger (1) gemessen werden.

5. Umwandlungselement (10) nach einem der vorstehenden Ansprüche, wobei der zweidimensionale Träger (1) Verbindungsabschnitte (4) zum Verbinden von zwei beliebigen benachbarten Pixelbereichen (ZP) aufweist und Aussparungen (5) aufweist, die jeden Verbindungsabschnitt quer begrenzen, so dass alle Pixelbereiche in dem zweidimensionalen Träger zusammenhängen, und so dass Wärmediffusionskanäle zwischen zwei benachbarten Pixelbereichen Abschnitte aufweisen, die durch einige der Aussparungen begrenzt sind.

6. Umwandlungselement (10) nach einem der vorhergehenden Ansprüche, wobei jede Terahertz-Antenne (2) eine Geometrie aufweist, die aus mehreren verschiedenen Geometrien ausgewählt ist, wobei die Terahertz-Antennen-Geometrien unterschiedlichen Polarisationen oder unterschiedlichen Wellenlängen für die elektromagnetische Strahlung entsprechen, die mit einer maximalen Effizienz absorbiert wird, und wobei jeder Pixelbereich (ZP) mindestens eine der Terahertz-Antennen-Geometrien (2) umfasst, vorzugsweise eine einzige Antennen-Geometrie, und wobei die Terahertz-Antennen-Geometrien zwischen Pixelbereichen, die unterschiedlich sind, abwechselnd angeordnet sind, vorzugsweise in einem Abwechslungsmuster, das in dem gesamten Umwandlungselement (10) identisch ist.

7. Umwandlungselement (10) nach einem der Ansprüche 1 bis 6, wobei die Terahertz-Antennen (2) einerseits und die Infrarot-Antennen (3) andererseits von zwei gegenüberliegenden Seiten des zweidimensionalen Trägers (1) gehalten sind, wobei die thermischen Widerstände entlang von Wärmediffusionswegen erzeugt werden, die den zweidimensionalen Träger zwischen den beiden gegenüberliegenden Seiten durchqueren.

8. Umwandlungselement (10) nach einem der Ansprüche 1 bis 6, wobei die Terahertz-Antennen (2) und die Infrarot-Antennen (3) gemeinsam auf einer gleichen Seite des zweidimensionalen Trägers (1) gehalten sind, wobei die Terahertz-Antennen beispielsweise in einem ersten Teil einer Schichtstruktur (ST) verteilt sind, die von der Seite des zweidimensionalen Trägers getragen wird, und die Infrarotantennen in einem zweiten Teil der Schichtstruktur verteilt sind, der sich oberhalb oder unterhalb des ersten Teils der Schichtstruktur befindet, in Bezug auf eine Stapel-Reihenfolge der Schichten auf der Seite des zweidimensionalen Trägers.

9. Verfahren zum Sammeln von Terahertz(TH)-Strahlung, wobei das Verfahren umfasst:
- Anordnen eines Umwandlungselements (10) nach einem der vorhergehenden Ansprüche in der Terahertz-Strahlung (TH), so dass das Umwandlungselement ausgehend von einer Energie der Terahertz-Strahlung eine Infrarot-Strahlung (IR) erzeugt; und
- Anordnen eines Infrarot-Strahlungssensors (20) auf einem Pfad der Infrarot (IR)-Strahlung, die durch das Umwandlungselement (10) erzeugt wird.

10. Verfahren nach Anspruch 9, wobei der Infrarot-Strahlungssensor (20) mindestens eine Photovoltaikzelle, oder eine photoleitende Zelle oder eine bolometrische Zelle umfasst, die wirksam ist, um mindestens einen Teil der Infrarotstrahlung (IR) zu absorbieren.

11. Verfahren nach Anspruch 9, wobei der Infrarot-Strahlungssensor (20) mindestens einen Bilddetektor umfasst, der für Infrarot (IR)-Strahlung empfindlich ist, und wobei das Verfahren ferner umfasst, ein für die Terahertz (TH)-Strahlung wirksames Objektiv (30) auf einem Weg der Terahertz-Strahlung stromaufwärts von dem Umwandlungselement (10) anzuordnen, und weiter ein für die Infrarot-Strahlung wirksames Bildgebungssystem (21) auf einem Weg der Infrarotstrahlung (IR) zwischen dem Umwandlungselement (10) und dem Bilddetektor (20) anzuordnen,
wobei das Objektiv (30) ein Bild einer Szene auf dem Umwandlungselement (10) mit der Terahertz (TH)-Strahlung erzeugt, die von der Szene stammt,
und wobei das Bildgebungssystem (21) ein Bild des Umwandlungselements (10) auf dem Bilddetektor (20) mit der Infrarotstrahlung (IR) erzeugt, die durch das Umwandlungselement produziert wird.

## Claims

1. Spectral conversion element (10) for electromagnetic radiation, comprising:
- a two-dimensional support (1), with juxtaposed zones (ZP) which are respectively dedicated to pixels;
- a set of first antennas (2), called Terahertz antennas, which are rigidly supported by the two-dimensional support (1) and sized to have a first absorption peak (P₁) for the electromagnetic radiation when a wavelength of the radiation is between 30 µm and 3 mm, corresponding to radiation referred to as Terahertz, at least one of the Terahertz antennas being situated inside each pixel zone (ZP); and
- a set of second antennas (3), called infrared antennas, which are also rigidly supported by the two-dimensional support (1) but sized to have a second absorption peak (P₂) for the electromagnetic radiation when the wavelength of the radiation is between 1 µm and 30 µm, corresponding to radiation referred to as infrared, at least one of the infrared antennas being situated inside each pixel zone (ZP);
the conversion element being arranged so that one of the Terahertz antennas (2) and one of the infrared antennas (3) which are both situated in one same pixel zone (ZP), whatever said pixel zone, are thermally coupled with each other, with a thermal resistance which is lower than each other thermal resistance which exists between any one of the Terahertz antennas and any one of the infrared antennas when said Terahertz and infrared antennas are situated in the respective pixel zones which are different,
so that the conversion element is adapted to produce an energy conversion within each pixel zone, between the Terahertz radiation which impinges onto each first antenna of said pixel zone and infrared radiation which is emitted by each second antenna of the same pixel zone.

2. Conversion element (10) according to claim 1, arranged so that each thermal resistance between one Terahertz antenna (2) and one infrared antenna (3) which are both situated in one same pixel zone (ZP), whatever said pixel zone, is lower than one tenth, preferably lower than one hundredth, of each other thermal resistance which exists between any one of the Terahertz antennas and any one of the infrared antennas when said Terahertz and infrared antennas are situated in the respective pixel zones which are different.

3. Conversion element (10) according to claim 1 or 2, wherein each Terahertz antenna (2) or infrared antenna (3) is of metal/dielectric/metal type, or is of Helmholtz resonator type, or is formed by a portion of a material which is absorbing for the infrared radiation or Terahertz radiation, respectively.

4. Conversion element (10) according to any one of the preceding claims, wherein each pixel zone (ZP) has transverse dimensions which are between 30 µm and 5000 µm, each Terahertz antenna (2) has a transverse dimension which is between 1 µm and 300 µm, and each infrared antenna (3) has a transverse dimension which is between 0.1 µm and 5 µm, said transverse dimensions being measured parallel to the two-dimensional support (1).

5. Conversion element (10) according to any one of the preceding claims, wherein the two-dimensional support (1) has connecting portions (4) to connect any two pixel zones (ZP) which are close to each other, and has recesses (5) which transversally limit each connecting portion, so that all the pixel zones are connected in said two-dimensional support, and that thermal diffusion passages between two pixel zones which are close to each other have sections limited by some of the recesses.

6. Conversion element (10) according to any one of the preceding claims, wherein each Terahertz antenna (2) has a geometry which is selected among several different geometries, said Terahertz antenna geometries corresponding to different polarisations or different wavelengths for the electromagnetic radiation which is absorbed with a maximum effectiveness, and wherein each pixel zone (ZP) comprises at least one of said Terahertz antenna geometries (2), preferably one single antenna geometry, and the Terahertz antenna geometries are alternated between pixel zones which are different, preferably according to an alternating pattern which is identical in the whole conversion element (10).

7. Conversion element (10) according to any one of claims 1 to 6, wherein the Terahertz antennas (2) on the one hand, and the infrared antennas (3) on the other hand, are supported by two opposing faces of the two-dimensional support (1), the thermal resistances being produced along thermal diffusion paths which cross the two-dimensional support between the two opposing faces.

8. Conversion element (10) according to any one of claims 1 to 6, wherein the Terahertz antennas (2) and the infrared antennas (3) are supported together by one same face of the two-dimensional support (1), for example the Terahertz antennas are distributed in a first part of a layered structure (ST) which is supported by the face of the two-dimensional support, and the infrared antennas are distributed in a second part of the layered structure which is situated above or below said first part of the layered structure, with respect to a layer stack order on the face of the two-dimensional support.

9. Method for collecting a Terahertz radiation (TH), said method comprising:
- arranging a conversion element (10) which conforms with any one of the preceding claims, in the Terahertz radiation (TH) so that the conversion element produces infrared radiation (IR) from energy of the Terahertz radiation; and
- arranging an infrared radiation sensor (20) on a trajectory of the infrared (IR) radiation which is produced by the conversion element (10).

10. Method according to claim 9, wherein the infrared radiation sensor (20) comprises at least one photovoltaic cell, one photoconductive cell, or one bolometric cell, effective for absorbing at least one part of said infrared (IR) radiation.

11. Method according to claim 9, wherein the infrared radiation sensor (20) comprises at least one image detector which is sensitive to the infrared radiation (IR), and the method further comprises arranging a lens (30) which is effective for the Terahertz radiation (TH) on a trajectory of said Terahertz radiation upstream of the conversion element (10), and also arranging an imaging system (21) which is effective for the infrared radiation on the trajectory of said infrared radiation (IR) between the conversion element (10) and the image detector (20),
the lens (30) forming an image of a scene on the conversion element (10) with the Terahertz radiation (TH) which originates from the scene,
and the imaging system (21) forming an image of the conversion element (10) on the image detector (20) with the infrared radiation (IR) which is produced by said conversion element.
